# EUROPEAN PATENT APPLICATION

(11) **EP 4 538 603 A1**
(43) Date of publication of application: **16.04.2025**
(21) Application number: 23819121.7
(22) Date of filing: 06.06.2023
(51) Int. Cl.: F24F 1/0018, F24F 1/0063, H05K 7/20

(54) **AIR CONDITIONER INDOOR UNIT**

(30) Priority: 06.06.2022 CN 202210634580; 06.06.2022 CN 202221410753 U
(71) Applicant: GD Midea Heating & Ventilating Equipment Co., Ltd., Foshan, Guangdong 528311 (CN); Hefei Midea Heating & Ventilating Equipment Co., Ltd., Hefei, Anhui 230601 (CN)
(72) Inventor: ZHU, Menghao, Foshan, Guangdong 528311 (CN); GU, Yong, Foshan, Guangdong 528311 (CN); LI, Yunzhi, Foshan, Guangdong 528311 (CN); KAN, Changli, Foshan, Guangdong 528311 (CN); ZHOU, Baisong, Foshan, Guangdong 528311 (CN); FENG, Zhengbo, Foshan, Guangdong 528311 (CN); WU, Lin, Foshan, Guangdong 528311 (CN)
(74) Representative: Haseltine Lake Kempner LLP
(86) International application number: PCT/CN2023/098629
(87) International publication number: WO 2023/236956

(57) **Abstract**

Provided is an air conditioner indoor unit. The air conditioner indoor unit includes a housing (10) and a blower assembly (20). The housing (10) is provided with an air supply duct (101) and an electric control chamber (102). The electric control chamber (102) is spaced apart from the air supply duct (101). The blower assembly (20) is disposed in the air supply duct (101) for driving an airflow. The electric control chamber (102) is provided with a drive module (11). The drive module (11) is electrically connected to the blower assembly (20). The electric control chamber (102) has a vent (103) for heat dissipation of the drive module (11).

## Description

### CROSS-REFERENCE TO RELATED APPLICATIONS

This application claims priority to Chinese Patent Application No. 202210634580.4, entitled "Air conditioner indoor unit", filed to the China Patent Office on June 06, 2022, the entire contents of which are incorporated herein by reference.

This application claims priority to Chinese Patent Application No. 202221410753.6, entitled "Air conditioner indoor unit", filed to the China Patent Office on June 06, 2022, the entire contents of which are incorporated herein by reference.

### FIELD

The present disclosure relates to the field of air conditioning technologies, and in particular, to an air conditioner indoor unit.

### BACKGROUND

With the development of society and economy, user's demands for air conditioners are increasing, simply adjusting an indoor temperature and inner humidity can no longer meet the needs of the user. Comfort of conditioned air has become a common goal pursued by the user while adjusting indoor environmental temperature. In an conditioner indoor unit in the related art air, a drive module would affects air outflowing, which is not conducive to the constant outflowing air volume from the air conditioner. In addition, operation stability of the drive module would be affected.

### SUMMARY

An object of the present disclosure is directed to propose an air conditioner indoor unit in which a drive module is disposed in an electric control chamber and a vent is formed for heat dissipation of an inner space of the electric control chamber, thereby facilitating stable operation of the drive module.

An air conditioner indoor unit according to an embodiment of the present disclosure includes a housing and a blower assembly. The housing is provided with an air supply duct and an electric control chamber. The electric control chamber is spaced apart from the air supply duct. The blower assembly is disposed in the air supply duct for driving an airflow. The electric control chamber is provided with a drive module. The drive module is electrically connected to the blower assembly. The electric control chamber has a vent for heat dissipation of the drive module.

According to the air conditioner indoor unit of the embodiment of the present disclosure, the drive module is disposed in the electric control chamber, and the vent is formed for the heat dissipation of the inner space of the electric control chamber, thereby facilitating the stable operation of the drive module.

In addition, the air conditioner indoor unit according to the above-mentioned embodiment of the present disclosure may further have the following additional technical features.

In an exemplary embodiment, the electric control chamber further is provided with a main control module. The drive module is electrically connected to the main control module.

In an exemplary embodiment, the drive module and the main control module are integrated at one circuit board.

In an exemplary embodiment, the main control module and the drive module are separate elements, and the drive module is mounted at the main control module.

In an exemplary embodiment, the drive module is disposed at the main control module vertically.

In an exemplary embodiment, the drive module and the main control module are in parallel to each other.

In an exemplary embodiment, the drive module is inclined relative to the main control module at a predetermined angle.

In an exemplary embodiment, the drive module is connected to a corner of the main control module.

In an exemplary embodiment, the main control module and the drive module are separate elements, and the drive module and the main control module are separately disposed in the electric control chamber.

In an exemplary embodiment, the electric control chamber further is provided with a drive module and a main control module. The electric control chamber has a first accommodation cavity and a second accommodation cavity spaced apart from each other. The main control module is disposed in the first accommodation cavity. The drive module is disposed in the second accommodation cavity. The drive module is electrically connected to the main control module. The drive module is electrically connected to the blower assembly.

In an exemplary embodiment, the second accommodation cavity is in communication with an outer space of the electric control chamber through the vent.

In an exemplary embodiment, the electric control chamber is a flat chamber. The first accommodation cavity and the second accommodation cavity are arranged in a predetermined direction perpendicular to a thickness direction of the electric control chamber. The main control module is disposed in the first accommodation cavity horizontally. The drive module is disposed in the second accommodation cavity horizontally or vertically. In an exemplary embodiment, the electric control chamber has at least two vents to define a heat dissipation channel between the vents in the electric control chamber.

In an exemplary embodiment, the drive module faces towards one of the at least two vents.

In an exemplary embodiment, the vent is formed at at least one of a side of the electric control chamber facing towards an air return side of the housing, a side of the electric control chamber facing towards an air supply side of the housing, a side of the electric control chamber facing towards the air supply duct, a side of the electric control chamber facing away from the air supply duct, a top wall of the electric control chamber, and a bottom wall of the electric control chamber.

In an exemplary embodiment, the vent is formed at a side wall of the electric control chamber and extends at least partially downwards in a direction from an inner side to an outer side of the electric control chamber.

In an exemplary embodiment, a dustproof net and/or a drying layer is provided at the vent.

In an exemplary embodiment, the air conditioner indoor unit further includes a radiator disposed inside the electric control chamber or at least partially located outside the electric control chamber. The radiator faces towards the vent.

In an exemplary embodiment, the vent faces towards a fin gap of the radiator.

In an exemplary embodiment, a heat exchanger is also included, and the heat exchanger is disposed in the housing.

### BRIEF DESCRIPTION OF THE DRAWINGS

FIG. 1 is a schematic view of an air conditioner indoor unit according to an embodiment of the present disclosure.
FIG. 2 is a schematic view of an electric control chamber of the air conditioner indoor unit shown in FIG. 1 in an open state.
FIG. 3 is a schematic view of an electric control chamber of an air conditioner indoor unit according to another embodiment of the present disclosure, in which a drive module and a main control module are integrated at one circuit board.
FIG. 4 is a top view of FIG. 3;
FIG. 5 is a schematic view of an electric control chamber of an air conditioner indoor unit according to another embodiment of the present disclosure, in which a drive module is mounted at a main control module vertically.
FIG. 6 is a schematic view of the drive module cooperating with the main control module in the embodiment shown in FIG. 5.
FIG. 7 is a side view of FIG. 6;
FIG. 8 is a schematic view of a radiator cooperating with a drive module shown in FIG. 5.
FIG. 9 is a schematic view of an electric control chamber of an air conditioner indoor unit according to another embodiment of the present disclosure, in which a fan for air dissipation is provided.
FIG. 10 is a schematic view of an electric control chamber of an air conditioner indoor unit according to still another embodiment of the present disclosure, in which a drive module and a main control module are separate elements, and the drive module and the main control module are separately arranged.
FIG. 11 is a schematic view of an electric control chamber of an air conditioner indoor unit according to still another embodiment of the present disclosure, in which a drive module and a main control module are separate elements, and the drive module and the main control module are separately arranged.
FIG. 12 is a schematic view of an electric control chamber of an air conditioner indoor unit according to another embodiment of the present disclosure, in which a drive module and a main control module are arranged in different accommodation cavities.
FIG. 13 is a schematic view of an electric control chamber of an air conditioner indoor unit according to another embodiment of the present disclosure.

Reference numerals:
air conditioner indoor unit 100, housing 10, air supply duct 101, electric control chamber 102, vent 103, first accommodation cavity 104, second accommodation cavity 105, partition 106, drive module 11, main control module 12, positioning edge 13, positioning hook 14, radiator 15, cooling fan 16, insulation support 17, blower assembly 20, blower 21, electric motor 22.

### DESCRIPTION OF EMBODIMENTS

Reference will now be made in detail to the embodiments of the present disclosure, examples of which are illustrated in the accompanying drawings in which same or similar reference numerals refer to the same or similar elements or elements having the same or similar functions throughout the drawings. The embodiments described below by reference to the drawings are exemplary, and are intended to explain the present disclosure, rather than being construed as limiting the present disclosure.

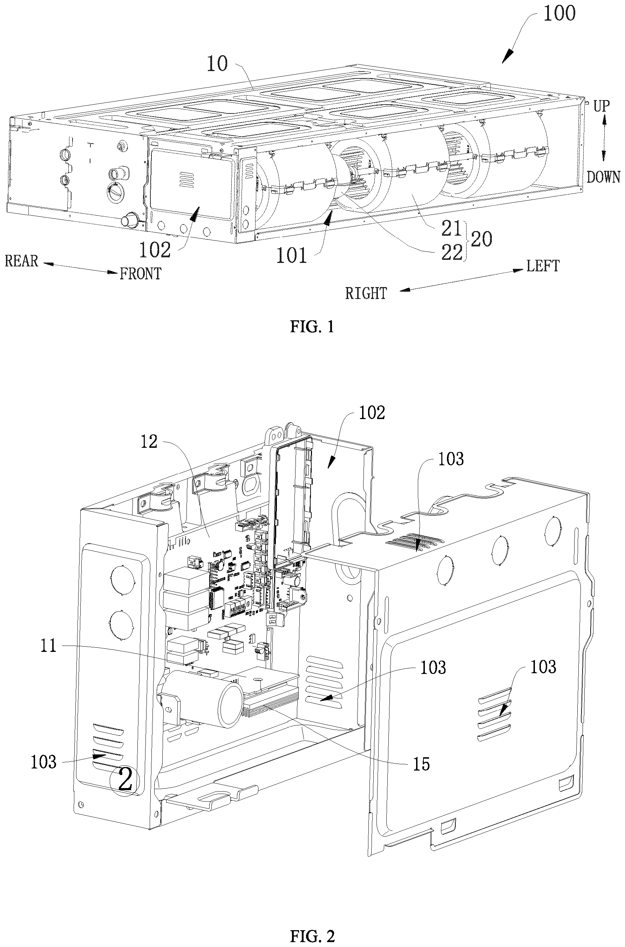

Referring to FIG. 1 and FIG. 2, an air conditioner indoor unit according to an embodiment of the present disclosure includes a housing 10 and a blower assembly 20. The housing is provided with an air supply duct 101 and an electric control chamber 102. The air supply duct 101 is spaced apart from the air supply duct 101. The blower assembly 20 is disposed in the air supply duct 101 for driving an airflow. The airflow can be driven by the blower assembly 20 to flow towards an air supply outlet from an air return inlet of the air supply duct 101. The electric control chamber 102 is provided with a drive module 11 therein. The drive module 11 is configured to drive the blower assembly 20 to operate. The drive module 11 is electrically connected to the blower assembly 20. The electric control chamber 102 has a vent 103 for heat dissipation of the drive module 11. During using, the drive module 11 can drive the blower assembly 20 to operate. When the drive module 11 is in operation, heat will be generated. By forming the vent 103, effective heat dissipation of the drive module 11 can be achieved, thereby improving heat dissipation efficiency and effect on the drive module 11. In addition, since the drive module 11 is integrated into the electric control chamber 102, signal communication between the drive module 11 and the main controller of the air conditioner indoor unit 100 can be facilitated, thereby easily controlling the drive module 11, which in turn improves control efficiency and control effect on the blower assembly 20.

According to the air conditioner indoor unit 100 of the embodiment of the present disclosure, the drive module 11 is disposed in the electric control chamber 102, and the vent 103 is formed for the heat dissipation of the inner space of the electric control chamber 102, a stable operation of the drive module 11 can be easily implemented, and the signal communication between the drive module 11 and the main controller of the air conditioner indoor unit 100 can be facilitated. Therefore, the control efficiency and the control effect on the blower assembly 20 can be improved.

In addition, the electric control chamber 102 and the air supply duct 101 may be spaced apart from each other. When the electric control chamber 102 is spaced apart from the air supply duct 101, the electric control chamber 102 and the air supply duct 101 may not be completely separated from each other. The vent may be formed between the electric control chamber 102 and the air supply duct 101 for communication therebetween. In this way, air can be driven by the blower assembly to circulate in the electric control chamber 102, thereby achieving the heat dissipation. In an exemplary embodiment, the electric control chamber 102 may be completely separated from the air supply duct 101.

In addition, the air conditioner indoor unit further includes a heat exchanger. The heat exchanger is disposed in the housing 10, and is adapted to exchange heat with the airflow.

The blower assembly 20 according to the embodiments of the present disclosure may include a blower 21 and an electric motor 22. The blower 21 is disposed in the air supply duct 101 for driving the airflow. The electric motor 22 is in transmission connection with the blower 21 to drive the blower 21 by the electric motor 22, thereby driving the airflow. The drive module 11 is electrically connected to the electric motor 22. The drive module 11 can drive the electric motor 22 to operate. In addition, the heat exchanger may be disposed in the housing 10. The blower 21 may drive the airflow through the heat exchanger to implement the heat dissipation.

In addition, the electric control chamber 102 may have at least two vents 103. In this way, a heat dissipation channel is defined between the vents 103 in the electric control chamber 102. By forming several vents 103, the airflow in the electric control chamber 102 can easily circulate. As a result, rapid heat dissipation within the electric control chamber 102 can be achieved. In addition, the electric control chamber 102 may have only one vent 103. In this case, the airflow may flow into the electric control chamber 102 through a slit at the electric control chamber 102 or be discharged through the slit, thereby forming a circulation passage for the airflow together with the vent 103. Further, a plurality of slits may be formed at the wall of the electric control chamber 102 to improve heat dissipation area and heat dissipation effect. Further, one vent 103 may be formed at the electric control chamber 102, and the airflow may pass through the vent for inflowing or outflowing.

In addition, as shown in FIG. 2, the air conditioner indoor unit 100 may include a main control module 12. The main control module 12 is configured to control an operation of the air conditioner indoor unit 100. The main control module 12 may be disposed in the electric control chamber 102, or at other positions in the air conditioner indoor unit 100. As shown in FIG. 2 to FIG. 12, in some embodiments of the present disclosure, the electric control chamber 102 is also provided with a main control module 12 therein. The drive module 11 is electrically connected to the main control module 12. The connection between the drive module 11 and the main control module 12 can facilitate signal transmission, thereby improving efficiency and effect of the signal transmission. Therefore, the drive module 11 and the main control module 12 each can be ensured to be in a stable state.

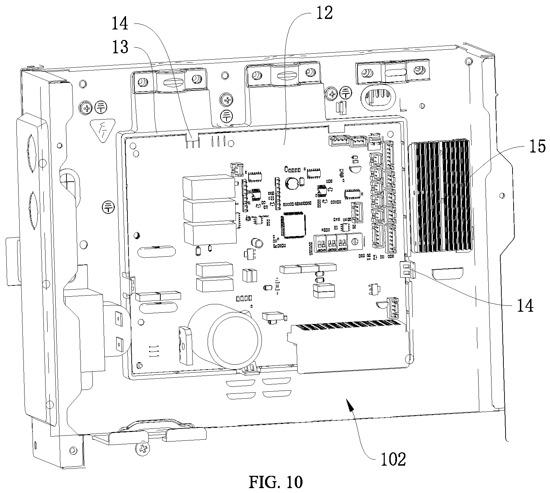

In an exemplary embodiment, as shown in FIG. 10, the electric control chamber 102 has a positioning edge 13 on an inner side surface of the electric control chamber 102. The positioning edge 13 defines a positioning recess at the inner side surface of the electric control chamber 102. The main control module 12 is disposed in the positioning recess. The positioning edge 13 is provided with a plurality of positioning hooks 14. The plurality of positioning hooks 14 is configured to prevent the main control module 12 from moving out of the electric control chamber 102. At least one of the plurality of positioning hooks 14 is constructed as an elastic hook. When mounting the main control module 12, the elastic hook is deformed to mount the main control module 12 into the positioning recess.

In addition, in the embodiment of the present disclosure, the drive module 11 and the main control module 12 may be separate elements, or the drive module 11 and the main control module 12 may be integrally formed. That is, the drive module 11 and the main control board may be integrated at one circuit board, or different circuit board structures may be provided for the drive module 11 and the main control module 12.

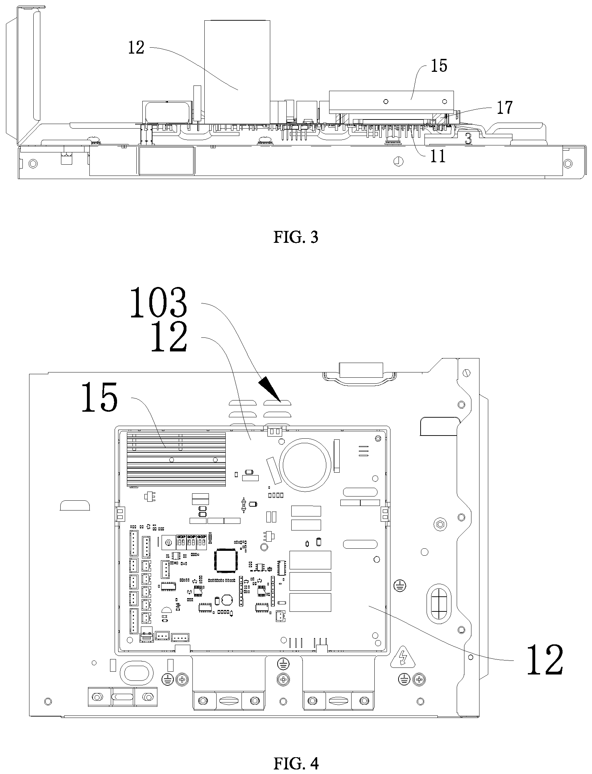

As shown in FIG. 3 and FIG. 4, in some embodiments of the present disclosure, the drive module 11 and the main control module 12 are integrated at one circuit board. By arranging both the drive module 11 and the main control module 12 in the electric control chamber 102, the number of structural components can be reduced. Further, a distance between the drive module 11 and the main control module 12 is shorter, and thus the signal transmission distance is shorter and the transmission speed is faster. In this way, an outflowing air volume of the air conditioner indoor unit 100 can be adjusted more quickly, and the blower assembly 20 can be easily controlled, thereby improving the heat dissipation efficiency of the drive module 11 and enhancing the heat dissipation effect. In addition, by arranging the drive module 11 and the main control module 12 in one electric control chamber 102, assembly efficiency of the air conditioner indoor unit 100 is higher during assembly of the air conditioner indoor unit 100. Therefore, the manufacturing cost can be lowered, and the later maintenance and overhaul can be facilitated.

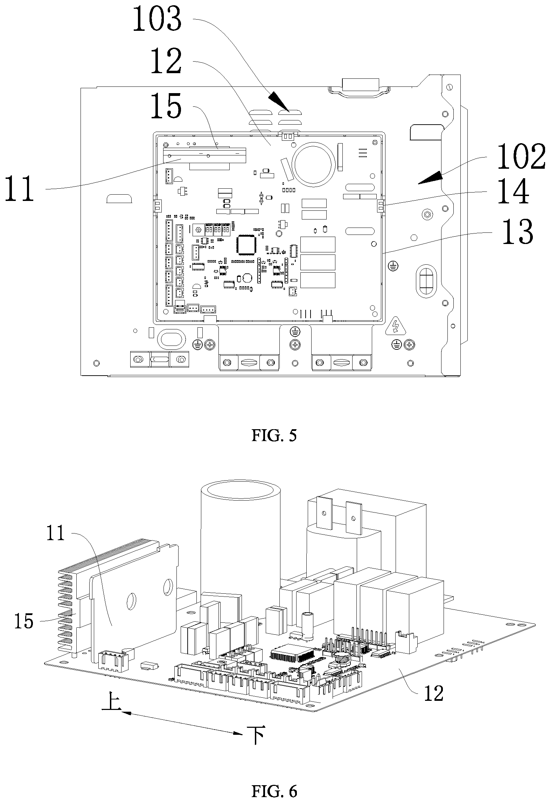

In other embodiments of the present disclosure, as shown in FIG. 5 to FIG. 12, the main control module 12 and the drive module 11 are separate elements. In this way, mutual interference between the main control module 12 and the drive module 11 can be reduced. Further, structures of the main control module 12 and the drive module 11 in the related art is less or hardly modified. As a result, cost of the air conditioner indoor unit 100 can be reduced.

The drive module 11 may be mounted to the main control module 12, or may be arranged separately from the main control module 12.

For example, in some embodiments, the drive module 11 may be mounted at the main control module 12, thereby achieving the integration of the drive module 11 and the main control module 12. The integration of the control module of the air conditioner indoor unit 100 is facilitated while less modifying the structures of the main control module 12 and the drive module 11. Further, the manufacturing, assembly, and maintenance of the air conditioner indoor unit 100 can be facilitated.

The drive module 11 and the main control module 12 may have different cooperating and positional relationships. As shown in FIG. 5 to FIG. 7, the drive module 11 may be disposed at the main control module 12 vertically. In this way, the space occupied by the drive module 11 can be reduced. In an exemplary embodiment, the main control module 12 typically has an arrangement such as a capacitor with a relatively large volume. By arranging the drive module 11 vertically, the space on the main control board can be fully used, thereby improving the space utilization rate. Therefore, the space occupied by a control module formed by combining the drive module 11 and the main control module 12 can be reduced.

In addition, the drive module 11 and the main control module 12 may also be in parallel with each other. In this case, in a projection perpendicular to the main control module 12, a projection of the drive module 11 may be completely or partially located on the main control module 12, or be completely located outside the main control module 12. For example, the drive module 11 may be connected to an edge of the main control module 12 to minimize the mutual interference between the main control module 12 and the drive module 11. The drive module 11 and the main control module 12 may also be opposite to each other in a normal direction of the main control module 12 (the left-right direction in FIG. 1). In this way, the space utilization is improved. Meanwhile, signal interference is also reduced and the heat dissipation is facilitated.

In addition, the drive module 11 may also be inclined relative to the main control module 12 at a predetermined angle. In this case, in the projection perpendicular to the main control module 12, the projection of the drive module 11 may be completely or partially located on the main control module 12, or completely located outside the main control module 12. For example, the drive module 11 may be connected to the edge of the main control module 12, and extend obliquely away from the main control module 12 or in an opposite direction to the normal direction of the main control module 12. Through the inclined arrangement of the drive module 11, the connection between the drive module 11 and the main control module 12 is facilitated. Further, the inclined arrangement can reduce the distance between the drive module 11 and the main control module 12. Therefore, the assembly and maintenance of the control module can be facilitated. Meanwhile, signal interference can be reduced, the heat dissipation can be facilitated.

In an exemplary embodiment, as shown in FIG. 4 and FIG. 5, in some embodiments of the present disclosure, the drive module 11 is mounted at a corner portion of the main control module 12. In conjunction with the foregoing, when the drive module 11 and the main control module 12 are integrated at one circuit board, electronic components of the drive module 11 may be integrated at the circuit board of the main control module 12 near an edge thereof. Likewise, when the drive module 11 and the main control module 12 are separate elements, the drive module 11 may be mounted at the circuit board of the main control module 12 near the edge thereof. In other embodiments, it is also possible to mount the drive module 11 at the corner position of the main control module 12 in other manners. In this way, heat dissipation of the drive module 11 can be facilitated, and interference of the drive module 11 with other components at the main control module 12 can be avoided. By connecting the drive module 11 and the main control module 12, with such a reasonable arrangement, a better heat dissipation effect can be provided while saving the space. Further, the drive module 11 and the main control module 12 are mounted and fixed by means of a specific structure, and thus the overall structure is stable and reliable.

The corner position of the main control module 12 may be located on the main control module 12 near the edge of the main control module 12. When the main control module 12 has several edges and a predetermined angle is formed between these edges, a region defined by two or more similar edges may be determined as a corner of the main control module 12. For example, the main control module 12 may be constructed into a rectangular shape. In this case, four corners of the main control module 12 are defined as the corner positions of the main control module 12. Likewise, when the main control module 12 is constructed into a triangular, pentagonal, and other shapes, each corner of the main control module 12 is defined as the corner position of the main control module 12. In addition, the main control module 12 may be constructed into a circular, oval, or other shape. In this case, likewise, a region of the main control module 12 adjacent to the edge thereof may be regarded as the corner position of the main control module 12.

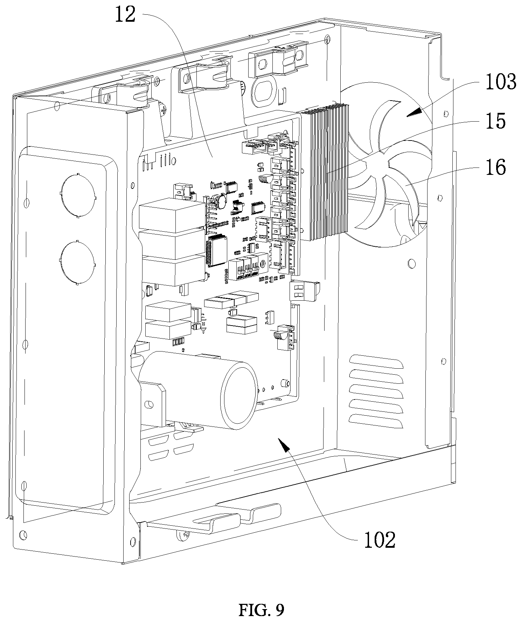

In addition, in conjunction with the foregoing description, the drive module 11 and the main control module 12 are separate elements. As shown in FIG. 9 to FIG. 12, the drive module 11 and the main control module 12 may also be arranged separately in the electric control chamber 102. That is, the drive module 11 and the main control module 12 are arranged at different positions in the electric control chamber 102. In this way, the stability and safety of operation can be improved. Further, the signal interference or mutual influence between the the drive module 11 and the main control module 12 can be avoided. Therefore, the air conditioner indoor unit 100 can be integrated and easily controlled. As a result, the modularization effect of the air conditioner indoor unit 100 is improved, and the signal transmission between the main control module 12 and the drive module 11 is facilitated. Therefore, the blower assembly can be easily controlled, and more complex drive requirements of the blower assembly can be satisfied.

The drive module 11 and the main control module 12 are arranged at different positions in one chamber. During the heat dissipation, the heat dissipation may be carried out on the electric control module and the drive module 11 simultaneously. Likewise, the drive module 11 and the main control module 12 may be disposed in different chambers. For example, a plurality of cavities is formed in the electronic control chamber 102 and arranged at intervals for storing the main control module 12 and the drive module 11, respectively.

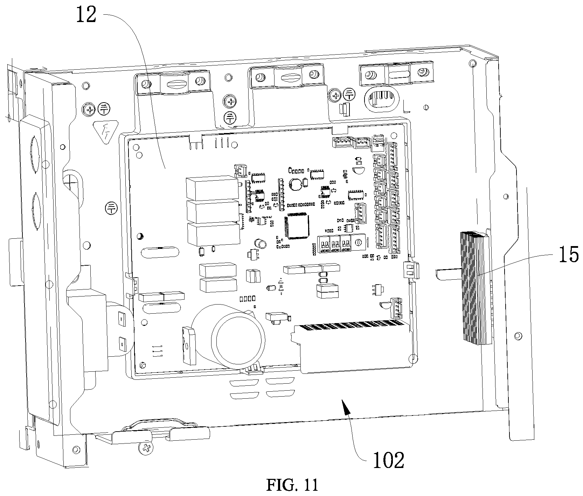

For example, as shown in FIG. 9 and FIG.10, the drive module 11 and the main control module 12 may be both arranged on the wall of the electric control chamber 102 horizontally. As shown in FIG. 11, it is also possible to dispose the main control module 12 on the bottom wall of the electric control chamber 102 horizontally, and to dispose the drive module 11 on a side wall of the electric control chamber 102 horizontally. The mounting positions and manners of the drive module 11 and the main control module 12 may be selected as desired.

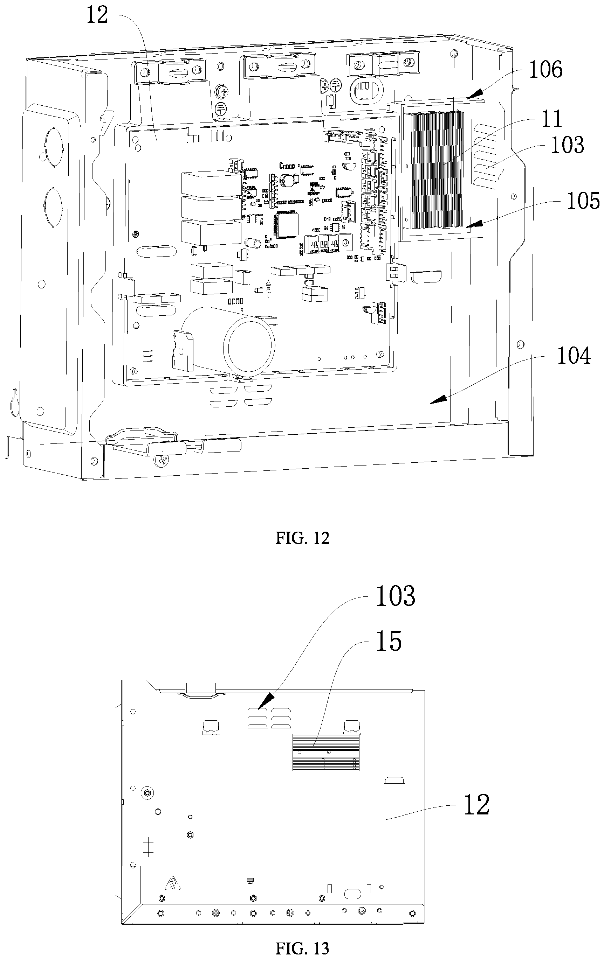

As shown in FIG. 12, in some embodiments of the present disclosure, the electric control chamber 102 has a first accommodation cavity 104 and a second accommodation cavity 105 spaced apart from each other. The main control module 12 is disposed in the first accommodation cavity 104. The drive module 11 is disposed in the second accommodation cavity 105. The drive module 11 is electrically connected to the main control module 12, and the drive module 11 is electrically connected to the blower assembly. The drive module 11 and the main control module 12 are respectively disposed in the first accommodation cavity 104 and the second accommodation cavity 105 of the electric control chamber 102. The drive module 11 and the main control module 12 may be arranged separately. In this way, the stability of operation is improved. The main control module 12 and the drive module 11 are separate elements to avoid the signal interference or the mutual influence between the main control module 12 and the drive module 11. Further, the drive module 11 is electrically connected to the blower assembly. The drive module 11 is adapted to drive the blower assembly to operate. Further, the drive module 11 is electrically connected to the main control module 12 to facilitate the main control module 12 to control the drive module 11, thereby better controlling the operation condition of the blower assembly. In the assembly process, the main control module 12 and the drive module 11 may be respectively loaded into the first accommodation cavity 104 and the second accommodation cavity 105. In this way, it is possible to improve the modularization effect of the air conditioner indoor unit 100. In addition, the signal transmission between the main control module 12 and the drive module 11 and the control on the blower assembly are facilitated, thereby satisfying more complicated drive requirements of the blower assembly.

In addition, the second accommodation cavity 105 is in communication with an outer space of the electric control chamber 102 through the vent 103. The vent 103 communicates the space outside the electric control chamber 102 and the second accommodation cavity 105 to allow the air inside the second accommodation cavity 105 to exchange heat with an outer environment of the electric control chamber 102. In this way, a temperature inside the second accommodation cavity 105 can be lowered.

In an exemplary embodiment, the electric control chamber 102 is a flat chamber. The first accommodation cavity 104 and the second accommodation cavity 105 are arranged in a predetermined direction. The main control module 12 is arranged in the first accommodation cavity 104 horizontally, and the drive module 11 is arranged in the second accommodation cavity 105 horizontally or vertically. The predetermined direction is perpendicular to a thickness direction of the electric control chamber 102. Since the electric control chamber 102 is the flat chamber, a space arrangement is facilitated. The main control module 12 is arranged in the electric control chamber 102 horizontally, and the drive module 11 may be arranged in the electric control chamber 102 horizontally (a normal line of the drive module 11 is parallel to the thickness direction of the electric control chamber 102) or vertically (the normal line of the drive module 11 is perpendicular to the thickness direction of the electric control chamber 102) as desired. In an exemplary embodiment, the electric control box may be located at a side of the housing 10 for the space arrangement and easy maintenance and repair. The thickness direction of the electric control chamber 102 refers to the left-right direction in FIG. 1.

The flat chamber means that a height dimension of the chamber is smaller than a length dimension and a width dimension thereof. In this case, a size occupied by the height of the chamber is small. By arranging the main control module 12 horizontally, the space inside the electric control chamber 102 can be fully utilized. Meanwhile, the drive module 11 has a small size, and thus the drive module 11 may be arranged based on the heat dissipation requirements to improve the heat dissipation effect.

In addition, the electric control chamber 102 and the air supply duct 101 are arranged in an axial direction of the blower assembly 20 (the left-right direction in FIG. 1). The first accommodation cavity 104 and the second accommodation cavity 105 are arranged in the axial direction of the blower assembly 20. Also, the first accommodation cavity 104 and the second accommodation cavity 105 may be arranged in a direction perpendicular to the axial direction of the blower assembly 20. Through the arrangement of the first accommodation cavity 104 and the second accommodation cavity 105, the drive module 11 and the main control module 12 can be conveniently mounted, thereby improving the space utilization rate of the electric control chamber 102. In addition, the heat and signal interference between the drive module 11 and the main control module 12 can be avoided, thereby improving the stability of the electric control chamber 102.

With reference to FIG. 1 and FIG. 12, the axial direction of the blower assembly 20 refers to the left-right direction in the drawings. In this case, the first accommodation cavity 104 and the second accommodation cavity 105 may be arranged in a front-rear direction. In addition, a plurality of layers of cavities may also be formed in the electric control chamber 102 in the axial direction of the blower assembly 20 to define the first accommodation cavity 104 and the second accommodation cavity 105. In addition, the first accommodation cavity 104 and the second accommodation cavity 105 may also be arranged inside and outside. For example, the first accommodation cavity 104 is arranged around the second accommodation cavity 105. In another embodiment, the second accommodation cavity 105 is arranged around the first accommodation cavity 104. In other embodiments, the arrangement of the first accommodation cavity 104 and the second accommodation cavity 105 in the present disclosure is merely some exemplary embodiments of the present disclosure and does not limit the scope of the present disclosure.

As shown in FIG. 12, in some embodiments of the present disclosure, the first accommodation cavity 104 and the second accommodation cavity 105 are arranged in a direction perpendicular to the axial direction. The first accommodation cavity 104 and the second accommodation cavity 105 may be arranged in the front-rear direction, an up-down direction, or the like in the drawings. In this way, a thickness dimension of the electric control chamber 102 in the axial direction of the blower assembly 20 can be reduced, thereby reducing a size of the whole machine. In addition, volumes of the air supply duct and the heat exchange module of the air conditioner indoor unit can be increased, thereby improving power and energy efficiency of the air conditioner indoor unit.

In addition, the main control module 12 is perpendicular to the axial direction, and the drive module 11 is perpendicular or parallel to the axial direction. Thus, the space in the electric control chamber 102 can be fully utilized, thereby improving the space utilization rate and heat exchange efficiency effect.

With reference to FIG. 12, a partition 106 is disposed in the electric control chamber 102. The second accommodation cavity 105 is defined by the partition 106 and a part of the wall of the electric control chamber 102. The vent 103 is formed at a part of the wall of the electric control chamber 102 engaged with the partition 106. In an exemplary embodiment, the partition 106 may define an accommodation space in the electric control chamber 102. The drive module 11 is mounted in the accommodation space. The drive module 11 may be separated from other components in the electric control chamber 102. In this way, the heat transfer from the drive module 11 to other components can be slowed down, and thus mutual interference can be avoided. In addition, in some other cases, the partition 106 may also act as a barrier when the drive module 11 or other components fail, thereby reducing risks and improving safety. Further, with the separated arrangement of the drive module 11, maintenance and repair can be facilitated. Furthermore, the vent 103 is formed at the part engaged with the partition 106. That is, the second accommodation cavity 105 is in communication with the outer space through the vent 103, which facilitates the heat in the second accommodation cavity 105 to be dissipated through the vent 103. Therefore, the ventilation effect of the second accommodation cavity 105 can be improved, which facilitates the heat dissipation of the drive module 11. Therefore, independent heat dissipation of the second accommodation cavity 105 can be achieved.

In addition, by constructed a part of the wall of the electric control chamber 102 as a wall of the second accommodation cavity 105, the vent 103 may be easily formed for the flowing of the airflow.

In some embodiments of the present disclosure, the first accommodation cavity 104 is configured as a sealed cavity. Thus, the main control module 12 in the first accommodation cavity 104 may be arranged separately from the drive module 11 in the second accommodation cavity 105 in the electric control chamber 102. Therefore, the main control module 12 can be effectively protected, thereby preventing external dust, water, or the like from entering the first accommodation cavity 104. In addition, it is possible to prevent external dust-containing airflow, water-containing airflow, or the like from entering the first accommodation cavity 104. As a result, the stability of the operation of the main control module 12 is improved, and condensation is also avoided. In other embodiments, the wall of the first accommodation cavity 104 may be made of a heat conducting material to exchange heat with the external environment, thereby achieving heat dissipation and cooling of the main control module 12.

With reference to FIG. 12, the partition 106 defines a U shaped structure inside the electric control chamber 102. An open end of the U shaped structure is connected to a wall of the electric control chamber 102, on which a vent 103 is formed. In this way, a second accommodation cavity 105 is defined. The drive module 11 is disposed in the second accommodation cavity 105 horizontally, and faces towards the heat dissipation plate. The heat dissipation plate covers above the drive module 11. Among other things, the second accommodation cavity 105 may be sized to allow for placement of the drive module 11 to improve space efficiency.

In the present disclosure, the electric control chamber 102 may be constructed by a wall of the housing 10 of the air conditioner indoor unit 100. Also, the electric control box may be disposed in the housing 10 to construct the electric control chamber 102 by the electric control box. In addition, the electric control box may include a metal outer shell and a plastic inner shell disposed inside the metal outer shell. In an exemplary embodiment, the inner shell of the electric control chamber 102 may be made of plastic, and has predetermined insulation and flammability. Therefore, the risk of electric leakage due to internal circuit failure can be reduced. The outer shell may be made of metal material, which has predetermined fire resistance and strong resistance to deformation. Therefore, it is possible to avoid the influence of excessive temperature on the external components of the electric control chamber 102 when the internal fire of the electric control chamber 102 occurs. In other embodiments of the present disclosure, the electric control chamber 102 may also be made of a refractory material. The electric control chamber 102 may be manufactured directly through injection-molded with the refractory material or integrally manufactured in other manners. The manufacturing steps are simpler and it is more convenient for manufacturing.

In addition, the vent 103 according to the embodiment of in the present disclosure may be formed at different positions on the electric control chamber 102. Different positions of the vent 103 may be selected as desired. The vents 103 may be formed at least one of a side of the electric control chamber 102 facing towards an air return side of the housing 10 (refer to a front side of the electric control chamber 101 in FIG. 1), a side of the electric control chamber 102 facing towards an air supply side of the housing 10 (refer to a rear side of the electric control chamber 101 in FIG. 1), a side of the electric control chamber 102 facing towards the air supply duct 101 (refer to a left side of the electric control chamber 101 in FIG. 1), a side of the electric control chamber 102 facing away from the air supply duct 101 (refer to a right side of the electric control chamber 101 in FIG. 1), a top wall of the electric control chamber 102 (refer to an upper side wall of the electric control chamber 101 in FIG. 1), and a bottom wall of the electric control chamber 102 (refer to a lower side wall of the electric control chamber 101 in FIG. 1). In this case, the air supply duct 101 has an air supply outlet and an air return inlet. The housing 10 has an air return side and an air supply side. Under the driving action of the blower assembly 20, the airflow at the air return side enters the air supply duct 101 through the air return inlet. After exchanging heat in the air supply duct 101, the airflow is delivered to the air supply side through the air supply outlet, and then enters indoors and returns to the air return side of the housing 10, thereby forming a heat exchange cycle.

For example, when the vent 103 is formed at the side of the electric control chamber 102 facing towards the air supply duct 101, the blower assembly 20 can drive the airflow through the electric control chamber 102 to dissipate heat of the electric control chamber 102. In addition, an air channel may be formed in the housing 10 to connect one or more vents 103 with the blower assembly 20. Also, as shown in FIG. 9, a cooling fan 16 or the like may be provided to separately drive the airflow in the electric control chamber 102 for circulation. In addition, the cooling and heat dissipation may be achieved by means of natural circulation between the air inside and outside the electric control chamber 102.

Note that the air inside the housing 10 is supplied to the air supply side of the housing 10 through the air supply outlet. The airflow outside the housing 10 may be supplied to the air return side of the housing 10 through the air return inlet. As shown in FIG. 1, in the housing 10, there is an air supply duct 101 extending in the front-rear direction. The air return inlet is formed at a front end of the air supply duct 101, and the air supply outlet is formed at a rear end of the air supply duct 101. Thus, the front side of the housing 10 is defined as the air return side of the housing 10, and the rear side of the housing 10 is defined as the air supply side of the housing 10. Further, since the electric control chamber 102 is disposed at a right side of the air supply duct 101, the left side of the electric control chamber 102 is defined as the side of the electric control chamber 102 facing towards the air supply duct 101, and a right side of the electric control chamber 102 is defined as the side of the electric control chamber 102 facing away from the air supply duct 101. In the description of the present disclosure, it should be understood that the directional or positional relationships indicated by the terms "upper", "lower", "front", "back", "left", "right" and the like are based on the directional or positional relationships shown in the drawings. It is merely for the purpose of describing the present disclosure and simplifying the description, rather than indicating or implying that a particular orientation, configuration and operation of the associated device or element is required, and thus should not be construed as limiting the present disclosure.

In addition, the drive module 11 may include electronic components such as an intelligent power module and a micro-control unit integrated circuit, to drive the blower assembly 20 to operate. In an exemplary embodiment, the blower assembly 20 may include one or more blowers. In this case, one, two or more blowers may be driven to rotate by the driving assembly. When the air conditioner indoor unit 100 includes a plurality of blowers, the plurality of blowers are distributed in a length direction (refer to the left-right direction in FIG. 1) of the air conditioner indoor unit 100.

As shown in FIG. 2, in some embodiments of the present disclosure, the vent 103 is formed at a sidewall of the electric control chamber 102, and the vent 103 at least partially extends downwards in a direction from the inner side to the outer side of the electric control chamber 102. Since the vent 103 at least partially extended downwards, when the airflow flows into the electric control chamber 102, even if there is dirt or other foreign matters or condensed water is generated, it is possible to block the dirt or other foreign matters or the condensed water from directly flowing into the electric control chamber 102 by the downward extending portion of the vent 103, thereby enhancing the protection to the electric control chamber 102. In addition, the airflow circulation is also ensured, and the effect of heat exchange can be improved.

In some embodiments of the present disclosure, a dustproof net and/or a drying layer are provided at the vent 103. By means of the dustproof net and the drying layer, it is possible to keep the airflow flowing into the electric control chamber 102 to be dry and dust-free, to avoid water and the like from flowing into the the electric control chamber 102 together with the airflow to generate the condensed water generated in the electric control chamber 102. Therefore, the electric control module can be operated stably.

After the drive module 11 is disposed in the electric control chamber 102, the drive module 11 becomes one of the main heat sources in the electric control chamber 102. Therefore, it is necessary to improve the heat dissipation effect on the drive module 11. In the present disclosure, the drive module 11 may be arranged at a position where the above-mentioned heat dissipation channel is located. Further, the drive module 11 may face towards the vent 103 to further enhance the heat dissipation effect. In addition, as described above, the electric control chamber 102 may have two or more vents 103, or a plurality of vents 103 may face towards the drive module 11 to further improve the heat dissipation effect on the drive module 11.

In order to further improve the heat dissipation effect on the electric control chamber 102 and maintain the operation stability of the drive module 11 and the like, in some embodiments of the present disclosure, the air conditioner indoor unit 100 further includes a radiator 15. The radiator 15 is disposed inside the electric control chamber 102 or at least partially outside the electric control chamber 102. When the radiator 15 is at least partially disposed inside the electric control chamber 102, the radiator 15 may face towards the vent 103 to remove heat of the radiator 15 by the airflow, thereby improving heat dissipation efficiency and effect within the electric control chamber 102. As shown in FIG. 13, the radiator 15 may be disposed in the electric control chamber 102, or the radiator 15 may at least partially extend out of the electric control chamber 102. The radiator 15 may carry heat out of the electric control chamber 102 to achieve the heat dissipation in the electric control chamber 102. By additionally providing the radiator 15, a contact area with air may be increased to improve the heat dissipation effect on the components in the electric control chamber 102.

With reference to FIG. 5 and FIG. 6, in some embodiments of the present disclosure, the drive module 11 is arranged horizontally. The drive chip of the drive module 11 is disposed at an upper part of the drive module 11. The radiator 15 is disposed above the drive chip and covers the drive chip. In an exemplary embodiment, since the air conditioner indoor unit 100 is typically arranged vertically and the drive module 11 is arranged horizontally, it is possible to make full use of the space of the air conditioner indoor unit 100 in the horizontal direction thereof, which is advantageous in reducing the volume of the air conditioner indoor unit 100. Further, the drive chip is disposed at the upper part of the drive module 11. In this way, one the one hand, the drive chip can face towards the radiator 15, and on the other hand, the radiator 15 can be positioned above the drive chip. As a result, the heat dissipation effect of the radiator 15 on the drive chip can be improved. Also, the radiator 15 can also shield the drive chip to avoid dust from being accumulated at the drive chip, thereby improving the dust-proof function and avoiding the operation of the chip from being affected. Moreover, space arrangement can be facilitated.

In addition, other electronic components in the drive module 11 may be disposed at a lower part of the drive module 11. In this way, the operating environment of the drive module 11 can be further maintained.

With reference to FIG. 5, in some embodiments of the present disclosure, the radiator 15 can completely cover the drive chip of the drive module 11, facilitating rapid cooling of the drive chip by the radiator 15. Further, a peripheral edge of the radiator 15 extends beyond the drive chip, and an air gap is formed between the peripheral edge of the radiator 15 and the drive module 11. In this way, the air gap between the peripheral edge of the radiator 15 and the drive plate can form an air channel, through which the air flows. Therefore, the heat dissipation effect can be enhanced, and the heat exchange area of the radiator 15 can be also increased.

In conjunction with FIG. 1 to FIG. 13, the radiator 15 according to the embodiments of the present disclosure may be mounted at the main control module 12, and may also be mounted at the wall of the electric control chamber 102. In the present disclosure, an insulation structure may be provided between the radiator 15 and the connection arrangement (such as the wall of the electric control chamber 102, the main control module 12 as mentioned above) to keep the operation stability of components in the electric control chamber 102. The air conditioner indoor unit 100 further includes an insulation support 17. The radiator 15 can be mounted on the connection arrangement by the insulation support 17, to improve the structural stability. In addition, a gap may be formed between the insulation support 17 and the radiator 15. When air is blown through the gap, heat may be taken away, thereby improving the heat dissipation effect.

In some embodiments of the present disclosure, the radiator 15 is connected to the drive module 11 and configured to exchange heat with the drive module 11. In this way, heat dissipation of the drive module 11 can be realized. Therefore, the heat dissipation effect can be improved, and stable operation of the drive module 11 is facilitated. In addition, overheating of the drive module 11 can be avoided, thereby prolonging the service life thereof.

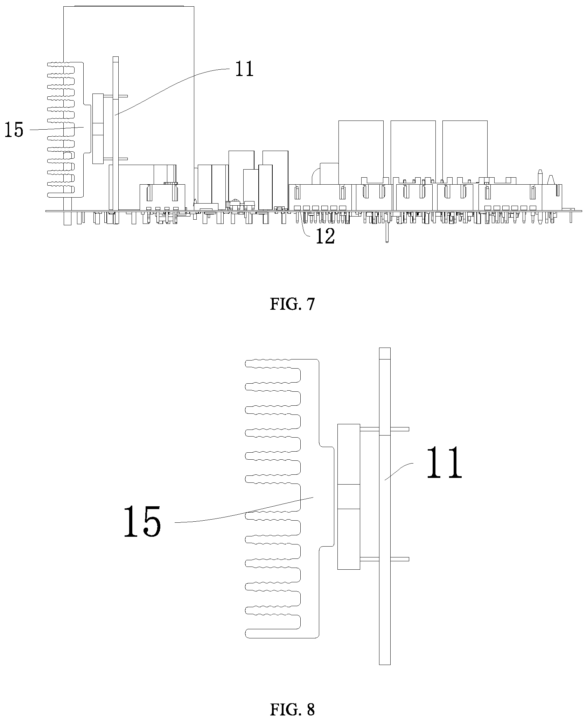

In conjunction with FIG. 8, in some embodiments of the present disclosure, the drive module 11 has a module pin, and the drive module 11 is connected to the main control module 12 by the module pin. Therefore, the separate connection between the drive module 11 and the main control module 12 can be achieved. Meanwhile, the drive module 11 can be controlled easily by the main control module 12, which facilitates the integration and reduces interference and influence between the drive module 11 and the main control module 12.

The drive module 11 may have one or more module pins. For example, the drive module 11 may have one pin, which can simplify the structure. A foil may be disposed at the module pin. The heat dissipation foil can further enhance the heat dissipation effect, and can avoid overheating at the connection between the drive module 11 and the main control module 12, thereby reducing interference between strong and weak electricity. The module pin has a stepped structure, which helps to improve the reliability of the overall structure. In an exemplary embodiment, one end of the module pin is inserted onto the main control module 12 of the main control module 12. Further, a stepped surface of the module pin is supported at the main control module 12. In this way, it is possible to increase a contact area of the module pin with the main control module 12 when being connected to the main control module 12, thereby improving the structural stability of the connection.

In an exemplary embodiment, a fin gap of the radiator 15 faces towards one of the vents 103. In an exemplary embodiment, the radiator 15 includes a plurality of fins extending in a first direction (refer to a direction perpendicular to the page in FIG. 8) and arranged at intervals in a second direction (refer to an up-down direction in FIG. 8). The plurality of fins faces towards at least one of the vents 3 in the first direction, thereby optimizing the heat dissipation effect.

In an exemplary embodiment, a temperature sensor for detecting a temperature may be disposed in the electric control chamber 102. When the electric control chamber 102 has a high temperature, the temperature sensor can give a prompt, thereby improving the operation safety of the air conditioner indoor unit 100. It is also possible to connect the temperature sensor to at least one of the drive module 11 and the radiator 15 or position the temperature sensor close to the drive module 11 to detect the temperature of the drive module 11, thereby rationally controlling the radiator 15.Therefore, the heat dissipation effect can be improved, thereby facilitating the energy saving.

The air conditioner indoor unit 100 may further include an electric control box disposed in the housing 10. The electric control box defines the electric control chamber 102. In an exemplary embodiment, the electric control box has a dustproof function, and thus can protect components inside the electric control chamber 102. In an exemplary embodiment, the electric control box may be located at a side of the housing 10 to allow for easy space arrangement and easy maintenance and repair. The electric control box may have a main body and a cover body. The main body and the cover body are removably connected to each other. The cover body may cover the main body to protect the components in the electric control chamber 102. When it is necessary to repair or replace the electric control chamber 102 and the main control module 12 or the drive module 11 inside the electric control chamber 102, the cover may be opened.

In the present disclosure, the drive module 11 is disposed in the electric control chamber 102, and the drive module 11 is disposed separately from the electric motor 22. Therefore, a flexible design of the drive module 11 is facilitated. For example, the circuits and interfaces on the drive module 11 may be flexibly designed to optimize the functions of the drive module 11. During use, the user may more conveniently repair and modify the drive module 11.

By arranging the drive module 11 in the electric control chamber 102, the assembly and maintenance are facilitated. During the overhaul of the drive module 11, it is not necessary to disassemble the blower assembly 20, thereby improving the efficiency of maintenance and avoiding damage occurring during the overhaul. Further, the drive module 11 may also be easily upgraded to meet the increasing functional demands on the air conditioner indoor unit 100. By arranging the drive module 11 in the electric control chamber 102, it is also possible to prevent the space in the air supply duct 101 from being affected due to the electrical motor 22 with too large volume when the drive module 11 is disposed in the electrical motor 22. Further, it is also possible to prevent the space in the air supply duct 101 from being occupied when the drive module 11 is disposed in the air supply duct 101, thereby increasing the air supply volume of the air supply duct 101.

Further, by arranging the drive module 11 in the electric control chamber 102, the remaining space in the electric control chamber 102 can be fully utilized. For example, since there are relatively bulky components such as capacitors and relatively small components such as resistors in the main control module of the electric control chamber 102, after assembling these components together, more space is left in the electric control chamber 102.

It can be seen that in the present disclosure, arranging the drive module 11 in the electric control chamber 102 would not affect other structures in the air conditioner indoor unit, and would not increase the space requirement for the electric control chamber 102. Therefore, the air conditioner indoor unit according to the embodiments of the present disclosure may be applied to existing air conditioner indoor units, thereby reducing cost of the mold. In addition, the upgrade, expansion, and the like of the drive module can be conveniently implemented. Only the drive module 11 is required to be replaced when the function of the drive module or the motor is required to be changed or added. During the manufacturing, the assembly, and the maintenance of the air conditioner indoor unit 100, it is possible to complete the update and change of the drive module 11 without modifying the whole structure of the air conditioner indoor unit 100, which will not change the assembly process and mold structure. As a result, costs can be reduced, and the modularization design of the air conditioner indoor unit is optimized. For example, for an air conditioner indoor unit with a constant air supply volume function and an air conditioner indoor unit without the constant air supply volume function, only the drive module is replaced without changing the manufacturing steps of the air conditioner indoor unit.

The embodiment of the present disclosure will be described by taking a duct type air conditioner as an example. The technical solution of the present disclosure is not limited to the duct type air conditioner, and may also be applied to an air conditioner indoor unit such as a ceiling-mounted air conditioner and a wall-mounted air conditioner.

Furthermore, the terms "first" and "second" are used for descriptive purposes only and are not to be construed as indicating or implying relative importance or implicitly indicating the number of technical features indicated. Thus, a feature defined by "first" or "second" may explicitly or implicitly include at least one such feature. In the description herein, "a plurality of" means at least two, e.g., two, three, etc. unless specifically and specifically limited otherwise.

In this application, unless expressly stated or limited otherwise, the terms "mounted," "connected," "connecting," "fixed" and the like are to be interpreted broadly, e.g., either fixedly or detachably, or integrally modularization. It may be a mechanical connection or an electrical connection. It may be a direct connection or indirect connection by an intermediary. It may be a communication between two elements, or may be in an interactive relationship between two elements, unless explicitly defined otherwise. The specific meaning of the above terms in this application will be understood in specific circumstances by those of ordinary skill in the art.

In this application, unless expressly stated or limited otherwise, "above" or "below" a first feature on a second feature may mean that the first and second features are in direct contact, or that the first and second features are in indirect contact by an intermediary. Further, the first feature being "on" or "above" the second feature may mean that the first feature is directly above or obliquely above the second feature or merely indicates that the first feature is at a higher level than the second feature. The first feature being "below" or "beneath" the second feature may mean that the first feature is directly below or obliquely below the second feature, or merely indicates that the first feature is at a lower level than the second feature.

In the description of this description, reference to the terms "an embodiment," "example," "a specific example," and "some examples," etc., means that specific features, structures, materials, or characteristics described in connection with the embodiment or example is included in at least one embodiment or example of the application. In the present specification, schematic statement of the above terms do not necessarily refer to the same embodiment or example. Furthermore, the particular features, structures, materials, or characteristics described may be combined in any suitable manner in any one or more embodiments or examples. Furthermore, the incorporations and combinations of the various embodiments or examples and features of the various embodiments or examples described in this description may be made by those skilled in the art without departing from the scope of the invention.

While embodiments of the present disclosure have been shown and described, it will be understood that the above-described embodiments are illustrative and are not to be construed as limiting the present disclosure, and that variations, modifications, substitutions, and alterations in the above-described embodiments may be effected by one of ordinary skill in the art without departing from the scope of the present disclosure.

## Claims

1. An air conditioner indoor unit, comprising:
a housing, provided with an air supply duct and an electric control chamber, the electric control chamber being spaced apart from the air supply duct; and
a blower assembly disposed in the air supply duct for driving an airflow, wherein:
the electric control chamber is provided with a drive module electrically, the drive module being connected to the blower assembly; and
the electric control chamber has a vent for heat dissipation of the drive module.

2. The air conditioner indoor unit according to claim 1, wherein the electric control chamber further is provided with a main control module, the drive module being electrically connected to the main control module.

3. The air conditioner indoor unit according to claim 2, wherein the drive module and the main control module are integrated at one circuit board.

4. The air conditioner indoor unit according to claim 2, wherein:
the main control module and the drive module are separate elements; and
the drive module is mounted at the main control module.

5. The air conditioner indoor unit according to claim 4, wherein:
the drive module is disposed at the main control module vertically; or
the drive module and the main control module are parallel to each other; or
the drive module is inclined relative to the main control module at a predetermined angle.

6. The air conditioner indoor unit according to any one of claims 3 to 5, wherein:
the drive module is disposed at a corner of the main control module.

7. The air conditioner indoor unit according to claim 2, wherein:
the main control module and the drive module are separate elements; and
the drive module and the main control module are separately disposed in the electric control chamber.

8. The air conditioner indoor unit according to claim 7, wherein:
the electric control chamber is provided with a drive module and a main control module;
the electric control chamber has a first accommodation cavity and a second accommodation cavity spaced from each other;
the main control module is disposed in the first accommodation cavity;
the drive module is disposed in the second accommodation cavity;
the drive module is electrically connected to the main control module; and
the drive module is electrically connected to the blower assembly.

9. The air conditioner indoor unit according to claim 8, wherein the second accommodation cavity is in communication with an outer space of the electric control chamber through the vent.

10. The air conditioner indoor unit according to claim 8, wherein:
the electric control chamber is a flat chamber;
the first accommodation cavity and the second accommodation cavity are arranged in a predetermined direction that is perpendicular to a thickness direction of the electric control chamber;
the main control module is disposed in the first accommodation cavity horizontally; and
the drive module is disposed in the second accommodation cavity horizontally or vertically.

11. The air conditioner indoor unit according to any one of claims 1 to 10, wherein a dustproof net and/or a drying layer is provided at the vent.

12. The air conditioner indoor unit according to any one of claims 1 to 11, wherein the drive module faces towards the vent.

13. The air conditioner indoor unit according to any one of claims 1 to 12, wherein the vent is formed at at least one of a side of the electric control chamber facing towards an air return side of the housing, a side of the electric control chamber facing towards an air supply side of the housing, a side of the electric control chamber facing towards the air supply duct, a side of the electric control chamber facing away from the air supply duct, a top wall of the electric control chamber, and a bottom wall of the electric control chamber.

14. The air conditioner indoor unit according to any one of claims 1 to 13, further comprising a radiator disposed inside the electric control chamber or at least partially located outside the electric control chamber, the radiator facing towards the vent.

15. The air conditioner indoor unit according to claim 14, wherein the vent faces towards a fin gap of the radiator.
